# EUROPÄISCHE PATENTANMELDUNG

(11) **EP 2 887 780 A1**
(43) Veröffentlichungstag der Anmeldung: **24.06.2015**
(21) Anmeldenummer: 14195334.9
(22) Anmeldetag: 28.11.2014
(51) Int. Cl.: H05K 3/46, H05K 1/02, H05K 3/06

(54) **Verfahren zur Herstellung von Hohlräumen bzw. Hinterschnitten in einer mehrlagigen Leiterplatte**

(30) Priorität: 19.12.2013 DE 102013226683
(71) Anmelder: ROBERT BOSCH GMBH, 70442 Stuttgart (DE)
(72) Erfinder: Ehrenpfordt, Ricardo, 70825 Korntal-Muenchingen (DE); Pantel, Daniel, 71254 Ditzingen (DE); Ante, Frederik, 70197 Stuttgart (DE)

(57) **Zusammenfassung**

Die Erfindung betrifft ein Verfahren zur Herstellung von Hohlräumen bzw. Hinterschnitten oder Kanälen in einer mehrlagigen Leiterplatte, mit den folgenden Schritten:
a) Bereitstellen einer mehrlagigen Leiterplatte (100), welche zumindest zwei Kerne (10, 20) aufweist, wobei zwischen den beiden Kernen (10, 20) ein Füllmaterial (30) angeordnet ist, welches den Raum zwischen den Kernen (10, 20) im Wesentlichen vollständig ausfüllt, und einer der Kerne (10) zumindest abschnittsweise im Bereich seiner Oberfläche eine Opferschicht (40) aufweist, welche an das Füllmaterial (30) angrenzt;
b) Einbringen einer erforderlichen Anzahl von Öffnungen (70, 80) zum Ätzen der mehrlagigen Leiterplatte (100), ausgehend von zumindest einer Oberfläche der mehrlagigen Leiterplatte (100), wobei sich die Öffnungen (70, 80) zum Ätzen bis zu der Opferschicht (40) erstrecken;
c) Ätzen der mehrlagigen Leiterplatte (100), solange bis die Opferschicht (40) aus der mehrlagigen Leiterplatte (100) zumindest teilweise entfernt ist, wobeidadurchein Hohlraum (90) im Inneren der mehrlagigen Leiterplatte (100) gebildet wird.

## Beschreibung

### Stand der Technik

Eine typische zweilagige Leiterplatte besteht aus dem sogenannten Core-Material und einer beidseitig auflaminierten Kupferfolie, in welche durch weitere Strukturierungs- und Ätzschritte das Zielleiterbild eingebracht wird. Für komplexere Schaltungen ist es möglich, mehrere dieser Cores mit einem sogenannten Prepreg zu verpressen, so dass beispielsweise 32 Leiterbildebenen in einer mehrlagigen Leiterplatte übereinander gestapelt werden können. Zweck des Prepregs ist es dabei, jegliche Hohlräume zwischen den einzelnen Cores (welche aufgrund der Leiterbildstrukturen eine Topographie haben) zu füllen, so dass keine Luft bzw. Über- oder Unterdruck im Inneren der Leiterplatte eingeschlossen wird.

Für besondere Anwendungen wie beispielsweise Sensorsubstrate oder Bauelemente der Leistungselektronik sind aber Hohlräume in Leiterplatten zwingend erforderlich. Diese umfassen Substrate mit speziellen vibrationsentkoppelnden Strukturen, Kanäle zur Luftkühlung oder spezielle Medienzugänge für beispielsweise Drucksensoren oder Mikrofone.

Ein aus dem Stand der Technik bekannter Ansatz zum Erzeugen von Hohlräumen in mehrlagigen Leiterplatten setzt einen sogenannten 'NoFlow'-Prepreg zwischen den Lagen der Leiterplatte ein. Hierbei wird ein spezieller Prepreg verwendet, welcher nur einige hundert Mikrometer beim Verpressen verfließt und somit einen Hohlraum zwischen zwei benachbarten Cores definieren kann. Beim Verpressen der Cores mit dem NoFlow-Prepreg kann es jedoch zu ungewollten Lufteinschlüssen kommen oder die Cores über dem Hohlraum werden eingedrückt, so dass keine Planarität der Außenlagen der mehrlagigen Leiterplatte mehr sichergestellt sein kann. Anschließend werden die benötigten Durchkontakte und gegebenenfalls weitere Öffnungen in den Hohlraum eingebracht. Nachteilig ist hierbei der hohe Preis für derartige spezielle Prepregs.

Ein Ansatz zur Erzeugung von Hohlräumen in Leiterplatten wird in der DE 199 62 422 C2 erläutert, welches ein Verfahren zur Herstellung von Mehrlagenleiterplatten mit stufenförmigen Aussparungen offenbart. Hierbei erfolgt zunächst die Ausbildung eines Schaltkreises bei jeder Leiterplatte, danach die Ausbildung eines Schlitzes bei jeder Leiterplatte, so dass Ausnehmungen mit verschiedenen Größen entstehen. Anschließend erfolgt das Einfüllen eines Abdichtmaterials in die Ausnehmungen, so dass Abdichtungen entstehen. Danach erfolgt das Verbinden der Leiterplatten miteinander, so dass eine Mehrschichtleiterplatte entsteht sowie das Ausbilden von Durchgangslöchern in der Mehrschichtleiterplatte, das Aufbringen eines galvanischen Metallüberzugs und Ätzen. Im Anschluß erfolgt eine Behandlung der Abdichtungen mit einer Lösung, wie zum Beispiel mit einer Natronlauge, um die Abdichtungen zu entfernen. Zum Schluß erfolgt das Entfernen derjenigen Bereiche der Leiterplatten, in denen keine Ausnehmungen ausgebildet sind, so dass eine mehrstufige Ausnehmung in der Mehrschichtleiterplatte entsteht. Nachteilig ist hierbei die große Vielzahl von Prozessschritten, wodurch dieser aufwändig wird, sowie die eingeschränkte Gestaltung der erzeugten Hohlräume.

### Offenbarung der Erfindung

Das gemäß dem Hauptanspruch definierte Verfahren zur Herstellung von Hohlräumen bzw. Hinterschnitten in einer mehrlagigen Leiterplatte weist den Vorteil auf, dass für das Füllmaterial nunmehr Standardmaterialien verwendet werden können, wodurch die vorstehend beschriebene Verwendung von speziellen Prepregs vermieden wird und somit die Kosten für die mehrlagige Leiterplatte gesenkt werden können. Dadurch können ganz allgemein sämtliche kostenintensiven Sondermaterialien, wie zum Beispiel das 'Noflow'-Prepreg oder temporäre Schmelzkleber, entfallen.

Darüber hinaus ist bei einer Verwendung von Kupfer als dem Material für die Opferschicht dieses bereits auf einer von einem Drittanbieter beziehbaren mehrlagigen Leiterplatte vorhanden bzw. kann von diesem gemäß dem Wunsch des Anwenders des Verfahrens entsprechend dem gewünschten Verwendungszweck mit Leichtigkeit konfiguriert werden. Zusätzlich dazu ist Kupfer ein Standardmaterial in der Leiterplattenindustrie und somit mit allen Prozessen und Maschinen kompatibel.

Der Kern der Erfindung ist es, die bereits bestehende Kupferlage eines Leiterplatten-Cores in einer mehrlagigen Leiterplatte als Opferschicht zu verwenden, so dass durch diese Hohlräume bzw. Hinterschnitte mit einem kostengünstigen Verfahren erzeugt werden können. Für dieses Verfahren sind zudem in vorteilhafter Weise weder Spezialmaterialien noch Spezialprozesse notwendig. Hierbei ergibt sich für das vorliegende Verfahren ein breites Einsatzgebiet, wie beispielsweise im Kontext von Sensoren oder Chips, wobei die Hohlräume bzw.Hinterschnitte beispielsweise als Medienzugänge für Sensoren (Druck, Gas, Akustik) verwendet werden können, um damit wiederum Kanäle zum Kühlen oder Strukturen zur Lötstressentkopplung zu realisieren. Aufgrund der Verwendung der Kupferlage als Opferschicht wird außerdem kein zusätzliches Material (wie beispielsweise ein Polymer) in der mehrlagigen Leiterplatte verpresst. Dies ist insbesondere hinsichtlich der Vermeidung von Kontaminationen der mehrlagigen Leiterplatte bzw. der zugehörigen Herstellungsanlagen vorteilhaft.

Gemäß einer weiteren Ausgestaltung des vorliegenden Verfahrens kann die Opferschicht eine Kupferschicht eines Kerns der mehrlagigen Leiterplatte sein. Hierbei handelt es sich um eine, in der Regel auflaminierte, Kupferfolie auf dem sogenannten Core-Material eines Kerns der mehrlagigen Leiterplatte. Die Prozessierung dieser Kupferschicht für das vorliegende Verfahren ist mit allen Prozessen und Maschinen kompatibel, wie sie in der Leiterplattenindustrie verwendet werden. Deshalb besteht in vorteilhafter Weise keine Kontaminationsgefahr von anderen Maschinen.

Bei dem vorliegenden Verfahren kann die Opferschicht eine Dicke zwischen 5 µm bis 500 µm aufweisen. Limitierend sind hierbei insbesondere die Fertigungstoleranzen des Leiterplattenherstellers. Besonders bevorzugt für Anwendungen im Bereich der Mikroelektronik kann die Opferschicht eine Dicke zwischen 30 µm bis 100 µm aufweisen. Für das vorliegende Verfahren ist es bevorzugt, die Opferschicht mittels Ätzen vollständig zu entfernen, so dass die daraus entstehenden Hohlräume eine maximale Größe aufweisen. Je nach Anwendungsgebiet kann es jedoch auch ausreichend sein, wenn die Opferschicht bis zu einer gewissen vorbestimmten Dicke, ausgehend von ihrer ursprünglich aufweisenden Dicke, entfernt wird.

Gemäß einer weiteren Ausgestaltung des vorliegenden Verfahrens kann das Füllmaterial ein Prepreg sein. Hierbei können in vorteilhafter Weise sämtliche Prepregs verwendet werden, welche für die Abdichtung des Inneren der mehrlagigen Leiterplatte geeignet sind. Insbesondere sollen bei dem vorliegenden Verfahren diejenigen Prepregs eingesetzt werden, welche diesen Zweck bei möglichst geringen Kosten erfüllen, so dass auf die Verwendung der bislang erforderlichen kostenintensiven Sondermaterialien verzichtet werden kann.

Bei dem vorliegenden Verfahren kann das Prepreg zwischen zwei angrenzenden Kernen der mehrlagigen Leiterplatte eingepresst sein. Dies realisiert in vorteilhafter Weise eine möglichst kostengünstige Verwendung eines handelsüblichen Prepregs in Inneren der mehrlagigen Leiterplatte.

Gemäß einer weiteren Ausgestaltung des vorliegenden Verfahrens kann des Weiteren ein Schritt des zumindest bereichsweisen Aufbringens einer Strukturierungsmaske auf erforderliche Oberflächen der mehrlagigen Leiterplatte vorgesehen sein, sowie nach dem Ätzen der mehrlagigen Leiterplatte ein Entfernen der Strukturierungsmaske von der mehrlagigen Leiterplatte erfolgen. Hierbei ist die Strukturierungsmaske bevorzugt eine Photomaske aus einem Lacksystem.

Gemäß einer weiteren Ausgestaltung des vorliegenden Verfahrens kann sich der Hohlraum im Inneren der mehrlagigen Leiterplatte zumindest abschnittsweise bis zu einer Oberseite oder einer Unterseite der mehrlagigen Leiterplatte erstrecken. Hierbei kann sich der Hohlraum bis zu einer freien Oberfläche der mehrlagigen Leiterplatte erstrecken und insbesondere in Verbindung mit einer zugehörigen Öffnung für das Ätzen eine Gestalt bilden, welche eine Dicken- oder Breitenrichtung der mehrlagigen Leiterplatte in einer (mehrteiligen) versetzten Anordnung durchläuft. Somit lassen sich beispielsweise Bereiche noch besser vor einer Verunreinigung schützen, welche im Bereich des Hohlraums angeordnet sind.

Bei dem vorliegenden Verfahren kann der Hohlraum im Inneren der mehrlagigen Leiterplatte als ein Hinterschnitt ausgebildet sein. Es ist somit gemäß dem vorliegenden Verfahren nun auch möglich, auf einfache Weise einen Hinterschnitt in mehrlagigen Leiterplatten zu erzeugen. Dadurch kann zum Beispiel ein innenliegender Bereich der mehrlagigen Leiterplatte vor externen Einflüssen effektiv geschützt werden. Des Weiteren können mit Hilfe des vorliegenden Verfahrens die Dimensionen der Hinterschnitte, Hohlräume oder Kanäle im Inneren der mehrlagigen Leiterplatte derart gering ausgebildet werden, insbesondere hinsichtlich ihrer Dicke, wie es bislang mit den bekannten Herstellungsverfahren aus dem Bereich der Leiterplattentechnik nicht möglich ist.

Gemäß einer weiteren Ausgestaltung des vorliegenden Verfahrens kann der Hohlraum im Inneren der mehrlagigen Leiterplatte zumindest abschnittsweise als ein Kanal ausgebildet sein. Der Kanal kann dabei zumindest abschnittsweise einen horizontalen und/oder einen vertikalen Verlauf aufweisen.

Gemäß einer weiteren Ausgestaltung des vorliegenden Verfahrens kann der Schritt des Einbringens einer erforderlichen Anzahl von Öffnungen zum Ätzen der mehrlagigen Leiterplatte mittels Kontaktfräsen oder mittels eines Laserverfahrens erfolgen. Hierbei dient die Opferschicht insbesondere als eine Stoppschicht, um beispielsweise beim Kontaktfräsen die erforderliche Bohrtiefe bis zum Erreichen der Opferschicht zu ermitteln.

Bei dem vorliegenden Verfahren kann der Hohlraum in der mehrlagigen Leiterplatte zum Abbau von Wärmespannungen der mehrlagigen Leiterplatte vorgesehen sein. Besonders bevorzugt kann der Hohlraum als eine Struktur zur Lötstressentkopplung im Bereich eines Lotballs verwendet werden, wodurch die Lebensdauer der mehrlagigen Leiterplatte wesentlich verlängert werden kann. Gemäß einer weiteren Ausgestaltung des vorliegenden Verfahrens kann die Strukturierungsmaske eine Photomaske aus einem Lacksystem sein, und die Photomaske nach ihrem Aufbringen auf die mehrlagige Leiterplatte für den nachfolgenden Schritt strukturiert werden. Hierbei können alle aus dem Stand der Technik bekannten Verfahren eingesetzt werden.

### Kurze Beschreibung der Zeichnungen

Die vorliegende Erfindung wird anhand der beiliegenden Zeichnungen erklärt. Es zeigt dabei
Figur 1 und 2: eine Ansicht von Verfahrensschritten zur Herstellung einer mehrlagigen Leiterplatte, welche zur Verwendung in dem vorliegenden Verfahren vorgesehen ist,
Figuren 3 bis 6: eine Ansicht von Verfahrensschritten zur Herstellung von einem Hohlraum in einer mehrlagigen Leiterplatte von Figur 1 gemäß der vorliegenden Erfindung, und
Figuren 7 bis 10: eine Ansicht unterschiedlicher Strukturen von Hohlräumen und eines Hinterschnitts für verschiedene Anwendungsgebiete, welche gemäß der vorliegenden Erfindung erzeugt wurden.

### Ausführungsformen der Erfindung

Bevor nachfolgend nun das Verfahren zur Herstellung von einem Hohlraum in einer mehrlagigen Leiterplatte gemäß der vorliegenden Erfindung beschrieben wird, sollen zunächst die wesentlichen Verfahrensschritte zur Herstellung einer mehrlagigen Leiterplatte erläutert werden, wie sie in dem vorliegenden Verfahren zum Einsatz kommt.

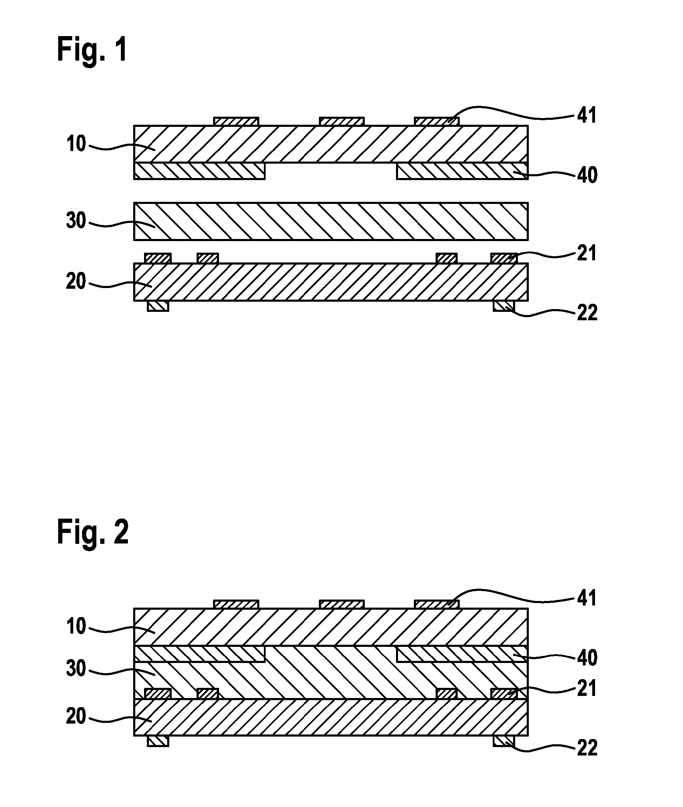

Bezugnehmend auf Figur 1 und 2 zeigen diese eine Ansicht von Verfahrensschritten zur Herstellung einer mehrlagigen Leiterplatte 100, welche zur Verwendung in dem vorliegenden Verfahren vorgesehen ist. Zunächst wird eine vierlagige Leiterplatte, bestehend aus zwei Kernen 10, 20 und einem Füllmaterial 30 in der Form eines handelsüblichen, standardisierten und kostengünstigen Prepregs, zu einem zusammenhängenden Bauteil verpresst. Besonders vorteilhaft bei dem vorliegenden Verfahren ist, dass nunmehr der Einsatz von Sondermaterialien, wie zum ein sogenantes 'Noflow'-Prepreg, entfallen kann. Der erste Kern 10 weist im Bereich seiner Innenseite eine innere Metalllage auf, welche als eine Opferschicht 40 vorgesehen ist. Insbesondere ist die Verwendung von Kupfer als Werkstoff für die Opferschicht 40 vorgesehen. Die Opferschicht 40 aus Kupfer ist bereits serienmäßig von Seiten des Herstellers des ersten Kerns 10 vorhanden, und muss dementsprechend also nicht mehr aufwändig vor den nachfolgenden Verfahrensschritten aufgebracht werden. Gegenüber liegend von der Opferschicht 40 ist an dem ersten Kern 10 eine weitere innere Metalllage 41 vorgesehen, welche ein Leiterbild enthalten kann. Der zweite Kern 20 weist im Bereich seiner Oberseite eine innere Metalllage 21 auf, welche ebenfalls ein Leiterbild enthalten kann. Außerdem weist der zweite Kern 20 im Bereich seiner Unterseite eine zweite Metalllage 22 auf, welche ebenfalls aus Kupfer gebildet sein kann. Nach dem Verpressen werden die beiden Außenlagen der Kerne 10, 20 mit Hilfe von Standardprozessen strukturiert (nicht dargestellt).

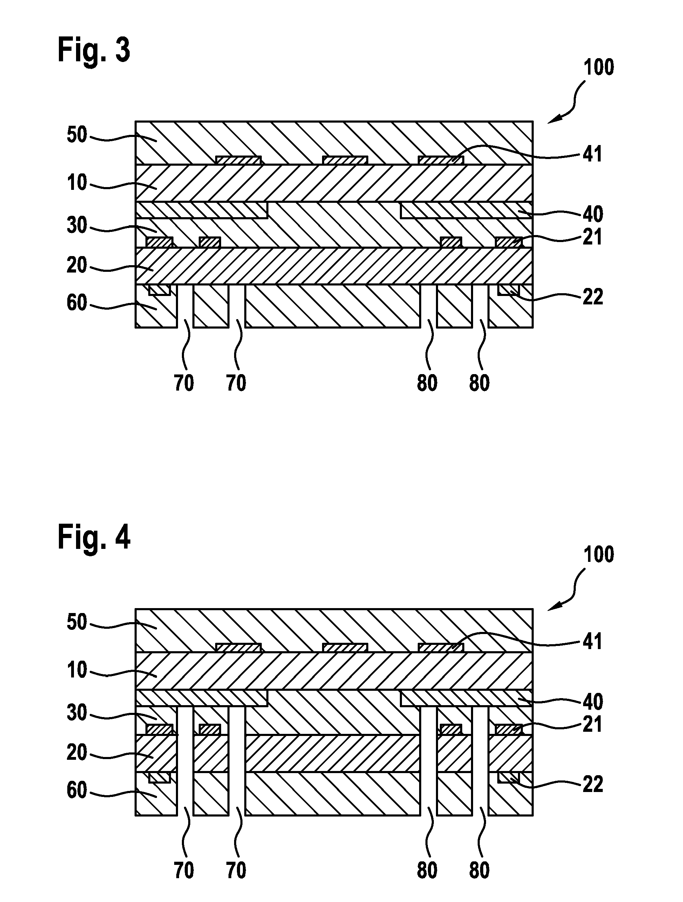

Figuren 3 bis 6 zeigen eine Ansicht von Verfahrensschritten zur Herstellung von einem Hohlraum in einer mehrlagigen Leiterplatte von Figur 1 gemäß der vorliegenden Erfindung. Figur 3 zeigt, wie auf die Konfiguration einer mehrlagigen Leiterplatte 100 gemäß Figur 2 Strukturierungsmasken in der Form von Photomasken 50, 60 aufgebracht sind, wobei die untere Photomaske 60 strukturiert ist. Zweck dieser Photomasken 50, 60 ist es, das Leiterbild auf den Außenlagen der beiden Kerne 10, 20 beim nachfolgenden Ätzen der Opferschicht 40 vor dem Auflösen zu schützen. Die Photomasken 50, 60 sind jeweils im Bereich der Oberseite des ersten Kerns 10 sowie im Bereich der Unterseite des zweiten Kerns 20 aufgebracht. Die Seiten der mehrlagigen Leiterplatte 100 sind frei von dem Material der Photomaske. Wenn die Metallstrukturen auf der Außenseite der mehrlagigen Leiterplatte 100 für das Ätzen nicht geschützt werden müssen, dann kann auf die Photomasken auch verzichtet werden.

Figur 4 zeigt wie anschließend eine Vielzahl von Öffnungen 70, 80 zum Ätzen in den zweiten Kern 20 und dem Füllmaterial 30 eingebracht sind, welche sich in der Gestalt eines Ausnehmung bis zu der Opferschicht 40 erstrecken.

Vorzugsweise erfolgt das Einbringen der Öffnungen 70, 80 zum Ätzen in die mehrlagige Leiterplatte 100 mittels Kontaktfräsen, wobei in vorteilhafter Weise die Opferschicht 40 als eine Stoppschicht verwendet werden kann.

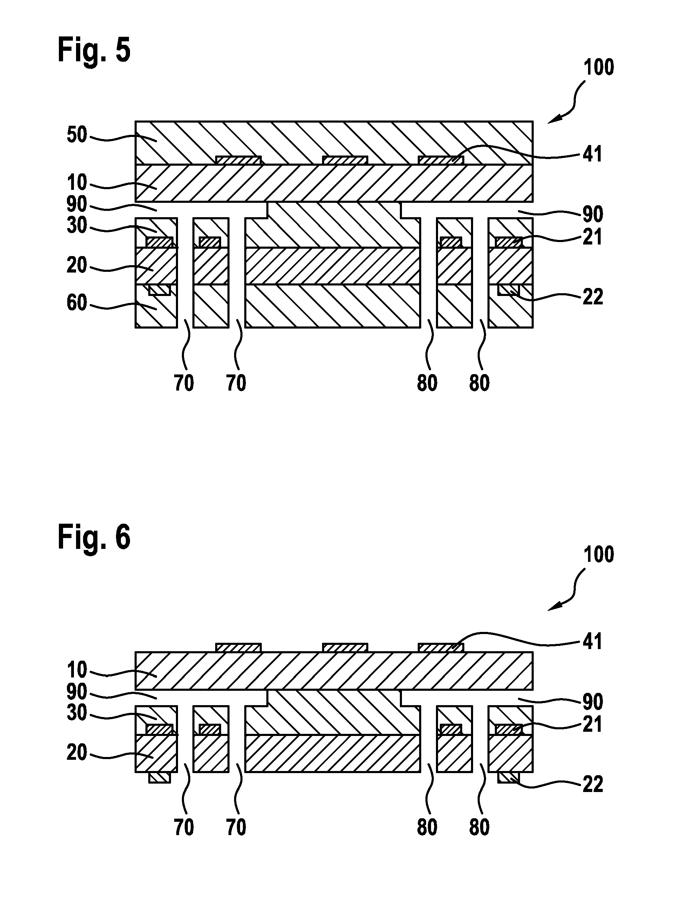

Figur 5 zeigt die mehrlagige Leiterplatte 100 nach einem mehrfachen Schleußen durch eine Ätzanlage (nicht dargestellt) des Leiterplattenherstellers, wobei infolge des Ätzens der Opferschicht 40 im Inneren der beiden Kerne 10, 20, jeweils durch das Einfüllen von einer Ätzsubstanz durch die Öffnungen 70, 80 zum Ätzen, die Opferschicht 40 mit der Ätzsubstanz in Kontakt kommt, von dieser zersetzt wird und dabei Hohlräume 90 im Inneren der mehrlagigen Leiterplatte 100 bildet.

Figur 6 zeigt die mehrlagige Leiterplatte 100 nach dem Entfernen der Photomasken in seiner finalen Konfiguration. Die Dicke des Hohlraums 90 bzw. eines Hinterschnitts (nicht dargestellt) kann durch die Dicke der Opferschicht eingestellt werden. Hierbei sind Dicken für die Operschicht, insbesondere aus Kupfer, von bis zu 70 µm durch Galvanisieren problemlos möglich. Vorteilhaft ist hierbei, dass die Opferschicht auch deutlich dünner als 10 µm (also lediglich einige Mikrometer) sein kann. Dadurch können Hinterschnitte bzw. Kanäle erzeugt werden, welche mit herkömmlichen Verfahren nicht möglich sind.

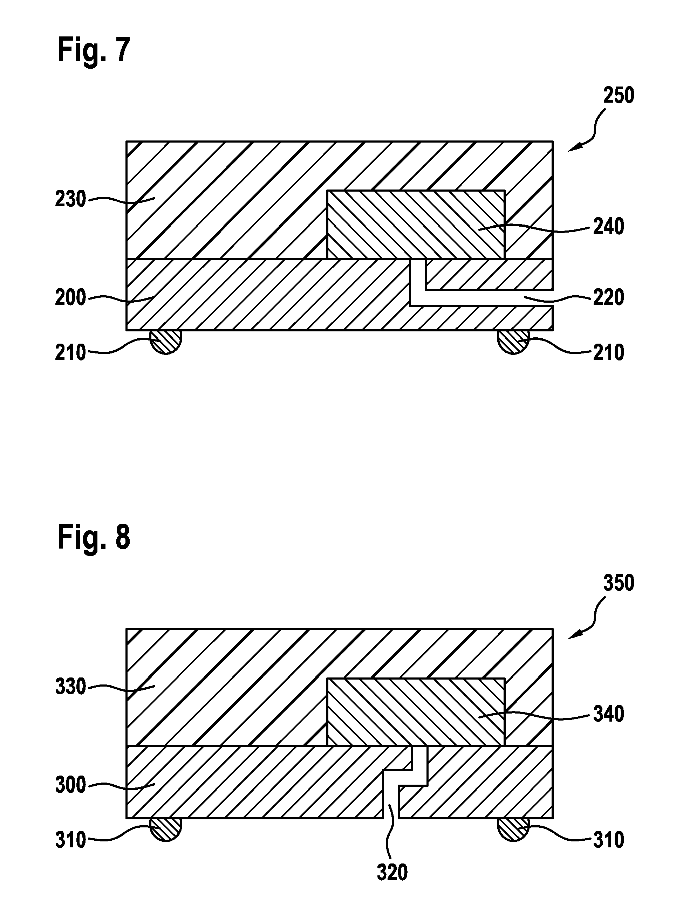

Figuren 7 bis 10 zeigen eine Ansicht unterschiedlicher Strukturen von Hohlräumen und eines Hinterschnitts für verschiedene Anwendungsgebiete, welche gemäß der vorliegenden Erfindung erzeugt wurden. Diese Strukturen wurden gegebenfalls aus einem größeren Teil (Leiterplattennutzen), welches gemäß dem vorliegenden Verfahren hergestellt wurde, zum Beispiel durch Fräsen, Sägen, Stanzen oder Lasern herausgetrennt. Grundsätzlich ergibt sich für das vorliegende Verfahren ein breites Einsatzgebiet, wie beispielsweise im Kontext von Sensoren oder Chips, wobei die Hohlräume bzw. Hinterschnitte beispielsweise als Medienzugänge für Sensoren (Druck, Gas, Akustik) verwendet werden können, um damit wiederum Kanäle zum Kühlen oder Strukturen zur Lötstressentkopplung zu realisieren.

Figur 7 zeigt eine beispielhafte Ausführungsform eines Sensors 250, welcher aus einer mehrlagigen Leiterplatte 200 besteht, auf welche im Bereich von seiner Oberseite ein Sensor 240 ausgebildet ist, welcher in einem Mold 230 eingebettet ist. Die mehrlagige Leiterplatte 200 weist im Bereich ihrer Unterseite Lotbälle 210 auf, kann jedoch auch nur metallisierte Flächen (nicht dargestellt) aufweisen. Zusätzlich weist die mehrlagige Leiterplatte 200 eine Öffnung 220 in der Art eines Medienzugangs auf, welche sich von der rechten Seite waagrecht bis zu dem Bereich des Sensors 240 erstreckt, und sich dann in vertikaler Richtung zu der Oberseite der mehrlagigen Leiterplatte 200 bis zu dem Sensor 240 erstreckt. Der waagrechte Abschnitt der Öffnung 220 ist dabei von der Unterseite der mehrlagigen Leiterplatte 200 um einen vorbestimmten Abstand beabstandet.Die Öffnung von Außen zum Sensor kann beispielsweise zur Detektion von Schall, Gasen oder Druck verwendet werden.

Figur 8 zeigt eine weitere beispielhafte Ausführungsform eines Sensors 350, welcher aus einer mehrlagigen Leiterplatte 300 besteht, auf welche im Bereich von seiner Oberseite ein Sensor 340 ausgebildet ist, welcher in einem Mold 330 eingebettet ist. Die mehrlagige Leiterplatte 300 weist im Bereich ihrer Unterseite wiederum Lotbälle 310 auf. Zusätzlich weist die mehrlagige Leiterplatte 300 eine Öffnung in der Art eines Hinterschnitts 320 auf, welcher sich von der Unterseite der mehrlagigen Leiterplatte 300 in vertikaler Richtung bis zu einer vorbestimmten Höhe erstreckt, sich dann in einem kurzen Übergangsbereich waagrecht erstreckt, um sich anschließend erneut in vertikaler Richtung bis zu dem Bereich des Sensors 340 zu erstrecken, so dass die beiden vertikalen Abschnitte der Öffnung zueinander versetzt sind. Hierdurch wird in effektiver Weise ein Schutz des Sensors 340 vor Lotspritzern während des Auflötens der mehrlagigen Leiterplatte 100 auf einer weiteren Platine (nicht dargestellt) oder ein Partikelschutz realisiert. Die Öffnung von Außen zum Sensor kann beispielsweise zur Detektion von Schall, Gasen oder Druck verwendet werden.

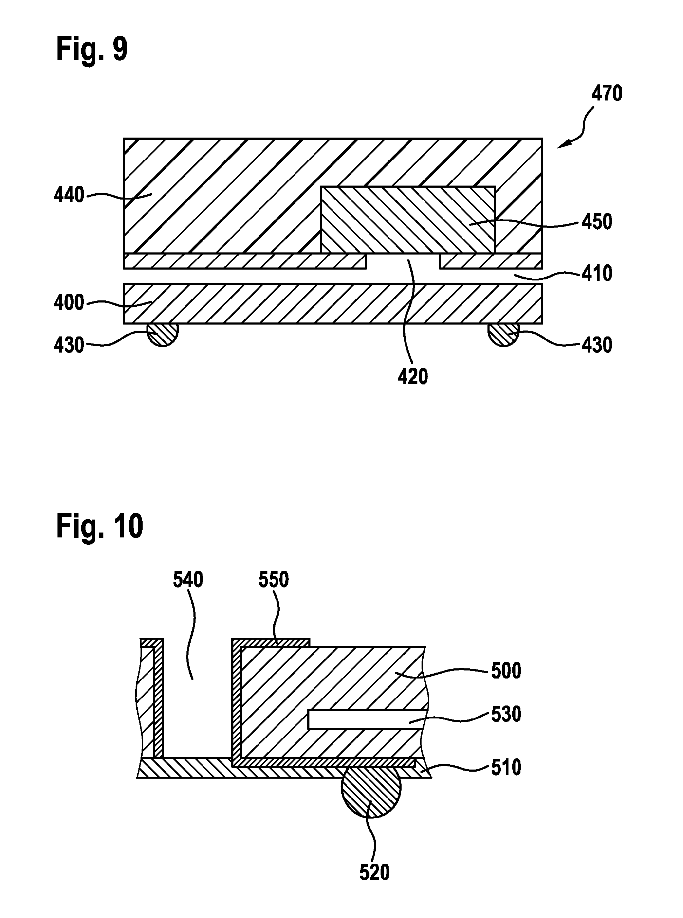

Figur 9 zeigt eine beispielhafte Ausführungsform eines Sensors 470, welcher aus einer mehrlagigen Leiterplatte 400 besteht, auf welche im Bereich von seiner Oberseite ein Sensor 450 ausgebildet ist, welcher in einem Mold 440 eingebettet ist. Die mehrlagige Leiterplatte 400 weist im Bereich ihrer Unterseite beispielsweise Lotbälle 410 auf. Zusätzlich weist die mehrlagige Leiterplatte 400 eine Öffnung 410 in der Art eines Medienzugangs auf, welche sich in waagrechter Richtung durch die gesamte Breite der mehrlagigen Leiterplatte 400 erstreckt. Zusätzlich dazu ist im Bereich unterhalb des Sensors 450 eine weitere Öffnung 420 im Inneren der mehrlagigen Leiterplatte 400 ausgebildet, welche sich ausgehend von der Öffnung 410 in vertikaler Richtung mit einer vorbestimmten Gestalt bis zu dem Bereich des Sensors 450 erstreckt. Die Öffnungen 410, 420 dienen dann zur Einleitung von Luft bzw. eines Fluids, welches insbesondere zur Kühlung des Sensors 450 vorgesehen ist. Alternativ können über diesen Kanal auch Schall, Druck oder Druck an den Sensor 450 geleitet werden.

Figur 10 zeigt eine weitere beispielhafte Ausführungsform einer mehrlagigen Leiterplatte 500, bei welcher in Schichtform ein Lötstoplack 510 auf deren Unterseite aufgebracht ist. Unterhalb des Lötstoplacks 510 ist ein Lotball 520 ausgebildet. Angrenzend an den Lotball 520 ist im Inneren der mehrlagigen Leiterplatte 500 ein Hohlraum 530 ausgebildet, welcher sich in waagrechter Richtung von der Außenseite der mehrlagigen Leiterplatte 500 bis im Wesentlichen zu dem Bereich des Lotballs 520 erstreckt. Der Hohlraum 530 ist von der Unterseite der mehrlagigen Leiterplatte 500 um einen vorbestimmten Abstand beanstandet. Angrenzend an den Hohlraum 530 ist ein Via 540 ausgebildet, dessen Oberfläche mit einer Kupferschicht 550 beschichtet ist. Bei dem vorliegenden Verfahren ist der Hohlraum 530 in der mehrlagigen Leiterplatte 500 in vorteilhafter Weise zum Abbau von Wärmespannungen vorgesehen. Besonders bevorzugt kann der Hohlraum 530 als eine Struktur zur Lötstressentkopplung im Bereich des Lotballs 520 verwendet werden, wodurch auch die Lebensdauer der mehrlagigen Leiterplatte 500 wesentlich verlängert werden kann.

## Patentansprüche

1. Verfahren zur Herstellung von Hohlräumen bzw. Hinterschnitten in einer mehrlagigen Leiterplatte, mit den folgenden Schritten:
a) Bereitstellen einer mehrlagigen Leiterplatte (100), welche zumindest zwei Kerne (10, 20) aufweist, wobei zwischen den beiden Kernen (10, 20) ein Füllmaterial (30) angeordnet ist, welches den Raum zwischen den Kernen (10, 20) im Wesentlichen vollständig ausfüllt, und einer der Kerne (10) zumindest abschnittsweise im Bereich seiner Oberfläche eine Opferschicht (40) aufweist, welche an das Füllmaterial (30) angrenzt;
b) Einbringen einer erforderlichen Anzahl von Öffnungen (70, 80) zum Ätzen der mehrlagigen Leiterplatte (100), ausgehend von zumindest einer Oberfläche der mehrlagigen Leiterplatte (100), wobei sich die Öffnungen (70, 80) zum Ätzen bis zu der Opferschicht (40) erstrecken;
c) Ätzen der mehrlagigen Leiterplatte (100), solange bis die Opferschicht (40) aus der mehrlagigen Leiterplatte (100) zumindest teilweise entfernt ist, wobei dadurch ein Hohlraum (90) im Inneren der mehrlagigen Leiterplatte (100) gebildet wird.

2. Verfahren nach Anspruch 1, **dadurch gekennzeichnet, dass** die Opferschicht (40) eine Kupferschicht eines Kerns (10) der mehrlagigen Leiterplatte (100) ist.

3. Verfahren nach Anspruch 1 oder 2, **dadurch gekennzeichnet, dass** die Opferschicht (40) eine Dicke zwischen 5 µm bis 500 µm aufweist.

4. Verfahren nach einem der vorherigen Ansprüche, **dadurch gekennzeichnet, dass** des Weiteren ein Schritt des zumindest bereichsweisen Aufbringens einer Strukturierungsmaske auf erforderliche Oberflächen der mehrlagigen Leiterplatte (100) vorgesehen ist, sowie nach dem Ätzen der mehrlagigen Leiterplatte (100) ein Entfernen der Strukturierungsmaske von der mehrlagigen Leiterplatte (100) erfolgt.

5. Verfahren nach einem der vorherigen Ansprüche, **dadurch gekennzeichnet, dass** sich der Hohlraum (90) im Inneren der mehrlagigen Leiterplatte (100) zumindest abschnittsweise bis zu einer Oberseite oder einer Unterseite der mehrlagigen Leiterplatte (100) erstreckt.

6. Verfahren nach einem der vorherigen Ansprüche, **dadurch gekennzeichnet, dass** der Hohlraum im Inneren der mehrlagigen Leiterplatte (200; 300) als ein Hinterschnitt (220; 320) ausgebildet ist.

7. Verfahren nach einem der vorherigen Ansprüche, **dadurch gekennzeichnet, dass** der Hohlraum im Inneren der mehrlagigen Leiterplatte (200; 400) zumindest abschnittsweise als ein Kanal (220; 410) ausgebildet ist.

8. Verfahren nach einem der vorherigen Ansprüche, **dadurch gekennzeichnet, dass** der Schritt des Einbringens einer erforderlichen Anzahl von Öffnungen (70, 80) zum Ätzen der mehrlagigen Leiterplatte (100) mittels Kontaktfräsens oder mittels eines Laserverfahrens erfolgt.

9. Verfahren nach einem der vorherigen Ansprüche, **dadurch gekennzeichnet, dass** der Hohlraum (530) in der mehrlagigen Leiterplatte (500) zum Abbau von Wärmespannungen der mehrlagigen Leiterplatte (500) vorgesehen ist.

10. Verfahren nach Anspruch 4, **dadurch gekennzeichnet, dass** die Strukturierungsmaske eine Photomaske (50, 60) aus einem Lacksystem ist, und die Photomaske (50, 60) nach ihrem Aufbringen auf die mehrlagige Leiterplatte (100) für den nachfolgenden Schritt strukturiert wird.
